# EUROPEAN PATENT SPECIFICATION

(11) **EP 3 200 340 B1**
(45) Date of publication and mention of the grant of the patent: **23.01.2019**
(21) Application number: 17152901.9
(22) Date of filing: 24.01.2017
(51) Int. Cl.: H02P 29/032, H02P 21/18, H02P 27/06, H02H 3/13, H02H 5/10

(54) **POWER CONVERSION DEVICE**
STROMWANDLUNGSVORRICHTUNG
DISPOSITIF DE CONVERSION D'ALIMENTATION ÉLECTRIQUE

(30) Priority: 26.01.2016 JP 2016012003
(43) Date of publication of application: 02.08.2017
(73) Proprietor: Hitachi, Ltd., Chiyoda-ku, Tokyo 100-8280 (JP)
(72) Inventor: XIA, Yongqiang, Tokyo 100-8280 (JP); TACHIHARA, Shuuichi, Tokyo 100-8280 (JP)
(74) Representative: Mewburn Ellis LLP

(56) References cited:
- EP-A1- 1 873 002
- EP-A1- 2 620 267
- JP-A- 2005 147 672
- US-A- 5 821 727

## Description

### BACKGROUND OF THE INVENTION

The present invention relates to a driving control device for a railway vehicle, and particularly to a power conversion device for a railway vehicle which has a function of detecting an abnormal state of a load motor in a driving system which supplies three-phase AC power from a power conversion device to the motor.

EP 2 620 267 A1 discloses a power conversion device that supplies one induction motor, detecting a connection failure based on a change in a d-axis or in a q-axis electric current component.

JP-A-2005-147672 discloses a method of detecting a connection failure in an output of an inverter which drives one load motor, in which a protection operation is performed by detecting an absolute value of a deviation between a Q-axis current command and a Q-axis current output, or an absolute value of a deviation between a D-axis current command and a D-axis current output.

In addition, JP-A-2005-176571 discloses a technique in which a disconnection of only one phase of one induction motor is detected when the torque exceeds a torque variation reference value within a predetermined time width in a system which performs vector control on one inverter to drive a plurality of induction motors connected in parallel.

### SUMMARY OF THE INVENTION

A connection failure in wiring a motor may occur in a railway electric vehicle in the middle of running, and may cause overheating and burnt-out accident of the motor.

For example, in a system which performs vector control on one inverter to drive a plurality (four) of induction motors connected in parallel, in a case where three of four induction motors become a connection failure state because of the connection failure and only the wiring to one induction motor is right, this state is the same circuit structure as that of the driving system which controls one induction motor disclosed in JP-A-2005-147672. Therefore, such a connection failure state is not possible to be detected even when a disconnection detecting device disclosed in JP-A-2005-147672 is applied to a system in which four induction motors are connected in parallel and driven.

In addition, in JP-A-2005-176571, the torque output from the induction motor is calculated, and a disconnection state of one induction motor is detected on the basis of a variation of the output torque. In a case where the variation of the output torque becomes small by feedback control in which the output torque is matched to a torque command value from a driving cab, the disconnection state is not possible to be detected with accuracy.

An object of the invention is to provide a power conversion device for a railway vehicle which can accurately detect a connection failure state such as a connection failure between an inverter and an induction motor, and an erroneous wiring of a reverse phase order.

A power conversion device according to an aspect of the invention includes: a current vector detecting unit that generates a torque current detection value and an exciting current detection value from a current detection value between the power conversion device and the plurality of induction motors; a slip frequency calculating unit that generates a slip frequency on the basis of a torque current command value and an exciting current command value; a speed estimating unit that generates an estimation speed of the induction motor on the basis of a deviation between the torque current detection value and the torque current command value; a connection failure detecting device that detects a connection failure of the plurality of induction motors on the basis of the exciting current detection value; and a voltage vector calculation unit that generates a voltage command value on the basis of the torque current command value, the exciting current command value, and an inverter frequency generated on the basis of the slip frequency and the estimation speed such that the torque current detection value follows the torque current command value.

According to the invention, a connection failure can be detected by an exciting current detection value even when there is no sensor installed to detect an opening of a connection portion, and the connection failure can be detected without causing an increase in cost of the device.

Other objects, features and advantages of the invention will become apparent from the following description of the embodiments of the invention taken in conjunction with the accompanying drawings.

### BRIEF DESCRIPTION OF THE DRAWINGS

FIG. 1 is a diagram illustrating an embodiment of a driving control device in the invention;
FIG. 2 is a diagram illustrating a state in which a wiring between an inverter and an induction motor (8D) is broken;
FIG. 3 is a diagram illustrating a state in which three-phase wirings are disposed in reverse order between the inverter and the induction motor (8D);
FIG. 4 is a diagram illustrating a determination condition for detecting a connection failure; and
FIG. 5 is a diagram illustrating another determination condition for detecting the connection failure.

### DESCRIPTION OF THE EMBODIMENTS

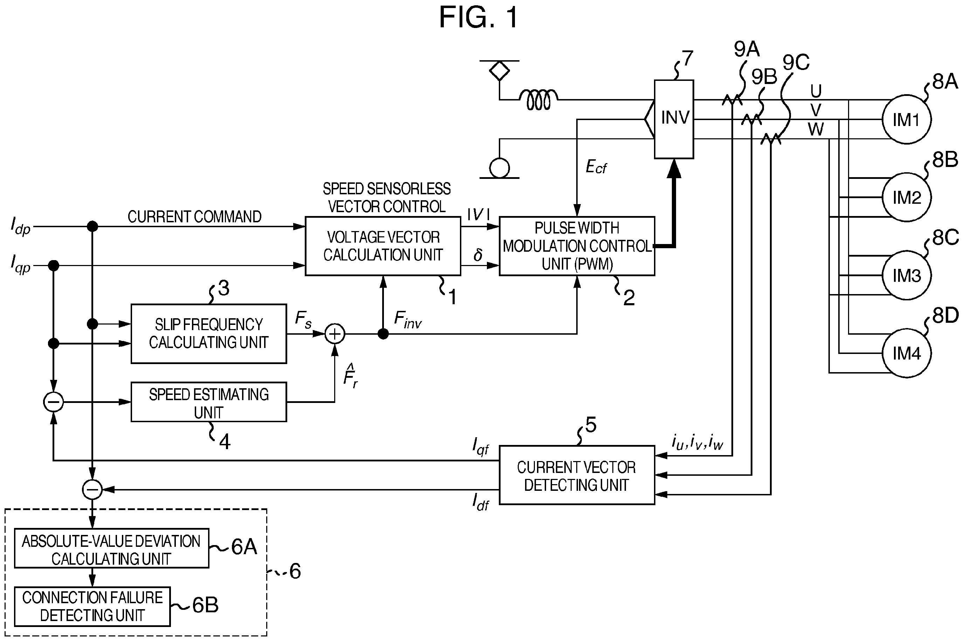

FIG. 1 is a block diagram illustrating control of a driving control device for a railway vehicle in a first embodiment of the invention. As illustrated in FIG. 1, DC power obtained through a pantograph is supplied to an inverter 7 through the wiring, and four induction motors 8A, 8B, 8C, and 8D are connected to the inverter 7 on an AC side. These four induction motors 8A, 8B, 8C, and 8D are connected in parallel to each other, and vector control is performed by one inverter 7. A switching element provided inside the inverter 7 performs switching on the basis of a gate signal output from a pulse width modulation control unit (PWM control unit) 2 to supply a desired AC power to four induction motors 8A, 8B, 8C, and 8D connected in parallel to the inverter 7.

The driving control device in this embodiment includes a voltage vector calculation unit 1 which outputs a voltage command value and a phase angle command on the basis of an exciting current command value Idp, a torque current command value Iqp, and an inverter frequency Finv, the pulse width modulation control unit (PWM) 2 which outputs a switching command of the inverter on the basis of the voltage command value, the phase angle command, the inverter frequency Finv, and a detected DC voltage value, a slip frequency calculating unit 3 which generates a slip frequency on the basis of the exciting current command value Idp and the torque current command value Iqp, a speed estimating unit 4 which generates an estimation speed on the basis of the torque current command value Iqp and a torque current detection value Iqf, a current vector detecting unit 5 which performs coordinate transformation on each output current of the inverter to generate a torque current component Iqf and an exciting current component Idf, and a connection failure detecting device 6 which detects a connection failure on the basis of a difference between the exciting current command value Idp and the exciting current component Idf.

The respective phase currents Iu, Iv, and Iw output from the inverter 7 are detected by phase current detectors 9A, 9B, and 9C. The detected phase currents Iu, Iv, and Iw are subjected to the coordinate transformation by the current vector detecting unit 5, and transformed into the torque current component Iqf and the exciting current component Idf. A difference between the torque current component Iqf and the torque current command value Iqp is input to the speed estimating unit 4. The speed estimating unit 4 generates a speed estimation value Fr by correcting a speed estimation value which is previously generated in speed estimation such that the difference between the torque current component Iqf and the torque current command value Iqp thus input becomes zero. In a case where an initial speed is estimated during an initial period immediately after the inverter is activated, there is no previous speed estimation value. Therefore, the speed estimating unit 4 corrects a predetermined initial speed estimation value to generate the speed estimation value Fr.

Herein, in a case where the initial speed is estimated during the initial period immediately after the inverter is activated, a minute exciting current is applied to generate a magnetic field in the motor so as to generate an electromotive force in proportion to speed. In a case where there is an error between the speed estimation value estimated by the speed estimating unit and the actual speed, a torque current Iq flows. Therefore, the speed estimation value can be matched to the actual speed by adjusting the speed estimation value such that the torque current Iq becomes zero by the speed estimating unit 4 even in the initial period immediately after the inverter is activated.

Furthermore, the estimation speed calculated by the above method by the speed estimating unit 4 and a slip frequency Fs output from the slip frequency calculating unit 3 are added by an adder to generate the inverter frequency Finv. The inverter frequency Finv is input to the voltage vector calculation unit 1. The voltage vector calculation unit 1 calculates a voltage vector command |V|, and outputs that command to the pulse width modulation control unit. The pulse width modulation control unit generates a pulse signal of which the width is modulated on the basis of the voltage vector command thus input, and controls the inverter in a pulse width modulation manner.

In this embodiment, there is performed a speed sensorless vector control in which the speed is estimated by the speed estimating unit 4 without installing a speed sensor in the motor. The speed sensorless vector control corrects the inverter frequency such that the torque current detection value Iqf follows the torque current command value Iqp in order to nullify the error in the estimation speed by using a phenomenon that a difference between the estimation speed and the actual speed becomes an error in the slip frequency which causes a deviation in torque current.

A motor feature is changed by a temperature change, and the torque of the induction motor is changed. In order to suppress the torque change, the exciting current is subjected to open loop control without performing a comparison between the detection value and the command value unlike the case of the torque current. With such control, an influence of a motor current change due to the temperature change is imposed by the exciting current, so that the torque change can be suppressed by suppressing the influence onto the torque current.

The inverter calculates a torque necessary for driving a vehicle in accordance with a variable load signal detected by a weight sensor which measures a weight of the vehicle, and a power running command and a brake command which are input by an operation of an operation lever (master controller) of a driving cab, and then calculates the torque current command value and the exciting current command value for outputting the necessary torque. In other words, the torque current command value and the exciting current command value are determined on the basis of the variable load signal and the operation amount of the master controller.

In the speed sensorless vector control described above, a connection failure detecting unit 6B can detect a disconnection state between the inverter 7 and at least one of the plurality of induction motors 8A, 8B, 8C, and 8D, and an erroneous connection state (reverse connection) in which the three phases (UVW) in one induction motor are connected in reverse order.

The connection failure detecting device 6 is configured by an absolute-value deviation calculating unit 6A and the connection failure detecting unit 6B. The absolute-value deviation calculating unit 6A detects a deviation between an absolute value of the exciting current Idf flowing to the induction motor and an absolute value of the predetermined exciting current command Idp. In a case where the connection failure such as an open-phase state or an erroneous wiring state of the reverse phase order occurs, the exciting current value becomes larger more than that at the normal time. Therefore, in a case where the deviation equal to or more than a predetermined value is kept on a certain time or more, it is determined as the open-phase state or the erroneous wiring state of the reverse phase order. In a case where the connection failure detecting device 6 determines the open-phase state or the erroneous wiring state of the reverse phase order, information indicating that the connection failure occurs is transmitted to the driving cab, or wirelessly transmitted to a maintenance factory so as to inform a driver or a service person about that the connection failure occurs. Herein, since the exciting current value when the connection failure occurs is increased in proportion to the exciting current command, the predetermined value for determining the connection failure may be a value which changes in proportion to the present exciting current command value, or may be a fixed value. Alternatively, the condition for determining the connection failure may include a case where the exciting current value is kept equal to or more than a value changing in proportion to the present exciting current command value and equal to or more than the fixed value for a certain time.

In the configuration of FIG. 1, in a case where the inverter is operating normally, a deviation between the exciting currents of the induction motor detected by the current detectors 9A, 9B, and 9C and the predetermined exciting current command value is kept at almost zero as long as equivalent constant values of the induction motors 8A, 8B, 8C, and 8D are not steeply changed.

The disconnection state between the inverter and the induction motor, and the erroneous connection state of the three-phase connection order (UVW) in the induction motor are difficult to detect before the inverter starts the operation. In addition, in a case where the invention is not used even in the state of these connection failures after the inverter starts the operation, the inverter control device recognizes the inverter as a normal state, and makes control such that the current flows as much as a predetermined torque current command value and a predetermined exciting current command value. For example, the exciting current and the torque current are controlled to be fed back in JP-A-2005-147672. Therefore, even in a case where an output torque is lowered due to the connection failure, the torque current command value and the exciting current command value are controlled to increase the output torque. Accordingly, it is not possible to accurately detect the state where the connection failure occurs in some of the plurality of induction motors.

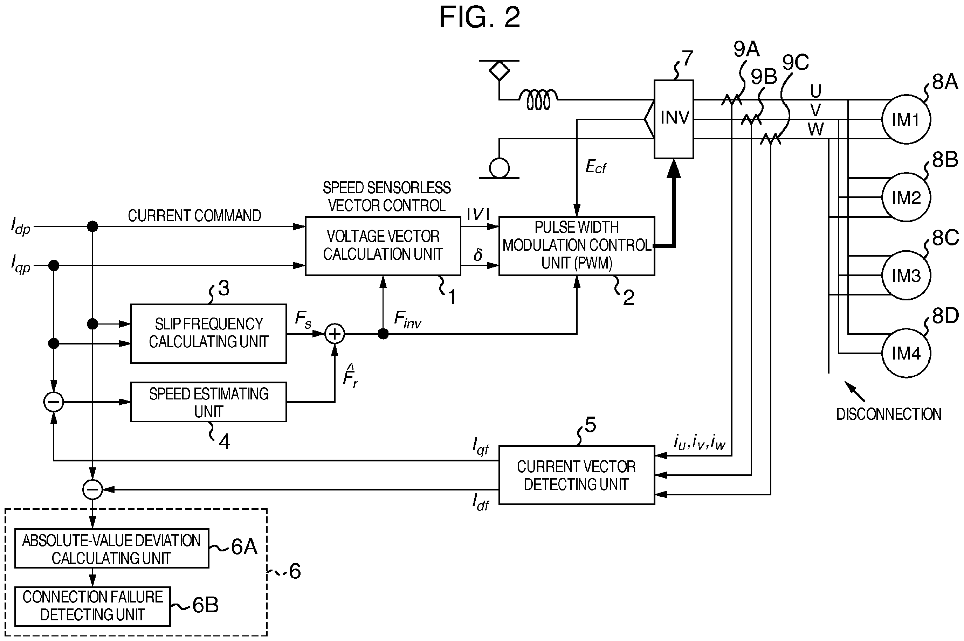

FIG. 2 illustrates an exemplary state in which the wiring between the inverter and the induction motor (8D) is disconnected. In a case where the wiring between the inverter and the induction motor is disconnected as illustrated in FIG. 2, the number of induction motors serving as the load is reduced, and the resistance value of the load is increased. Therefore, a total output torque from the plurality of induction motors flowing to the induction motor is reduced compared to that at a normal time. Herein, in the control of this embodiment described above, the torque current is subjected to the ACR control described above so that the current is fed back to match the torque current value to the torque current command value, and the exciting current is subjected to the open loop control without performing a comparison between the detection value and the command value unlike the case of the torque current. Therefore, all of large behavior caused by the correction of the motor current in accordance with the increase in load resistance is reflected on the exciting current. In this embodiment, large behavior in accordance with the increase in load resistance is reflected on the exciting current, and the connection failure detecting unit 6B detects the open-phase state between the inverter and the induction motor on the basis of a magnitude of the deviation between the detected exciting current value and the exciting current command value. In this way, according to this embodiment, the connection failure is determined on the basis of the detection value of the exciting current on which large behavior in accordance with the increase in load resistance is reflected. Therefore, the connection failure can be determined with more accuracy. While FIG. 2 shows an example in which one phase of the induction motor 8D is disconnected, large behavior in accordance with the increase in load resistance is similarly reflected on the exciting current even in a case where all the three phases of the induction motor 8D are disconnected. Therefore, the disconnection state can be detected with more accuracy.

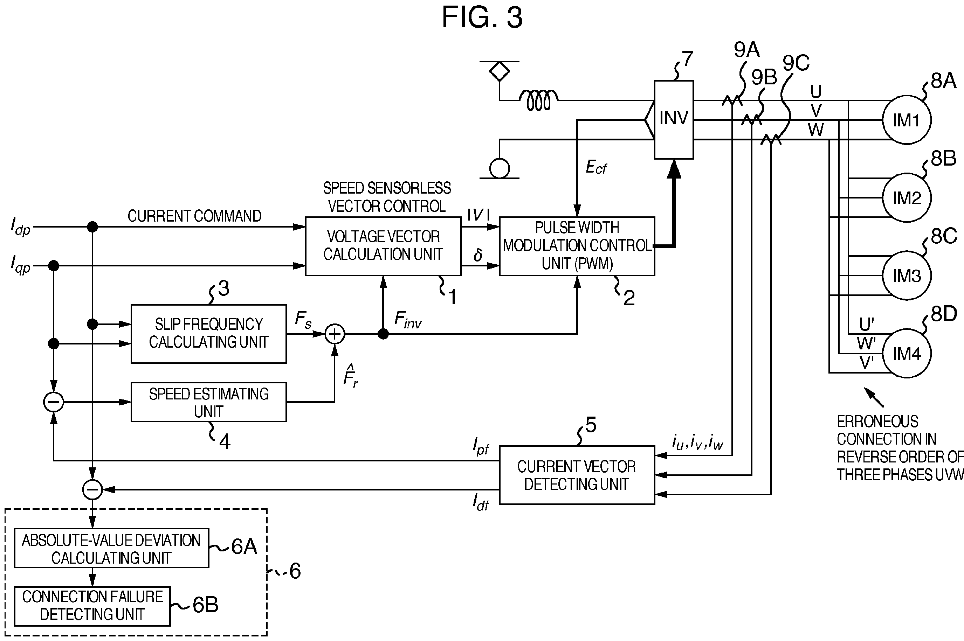

FIG. 3 illustrates an example of a state in which the three-phase wirings are connected in reverse order between the inverter and the induction motor (8D). In the case of the erroneous connection state where the three-phase wirings of the induction motor (8D) are connected in reverse order as illustrated in FIG. 3, the induction motors 8A, 8B, and 8C generate the torque in a direction determined by the control while the induction motor 8D generates the torque in a direction reverse to the direction determined by the control. Therefore, since the output torque of the reverse direction of the induction motor 8D and the output torque of the induction motor 8C are cancelled, the total output torque becomes an amount as much as that of two induction motors, and the actual torque becomes smaller than that of four induction motor. Herein, in the control in the embodiment described above, the torque current is subjected to the ACR control described above so that the current is fed back to match the torque current value to the torque current command value, and the exciting current is subjected to the open loop control without performing a comparison between the detection value and the command value unlike the case of the torque current. Therefore, all of large behavior caused by the correction of the motor current in accordance with the increase in load resistance is reflected on the exciting current. In this embodiment, large behavior in accordance with the increase in load resistance is reflected on the exciting current, and the connection failure detecting unit 6B detects the erroneous wiring state of the reverse UVW-phase order of the induction motor on the basis of a magnitude of the deviation between the detected exciting current value and the exciting current command value. In this way, according to this embodiment, the connection failure is determined on the basis of the detection value of the exciting current on which large behavior in accordance with the increase in load resistance is reflected. Therefore, the erroneous wiring state of the reverse UVW-phase order of the induction motor can be determined with more accuracy.

As described in this embodiment, in the speed sensorless vector control in which a rotation frequency of the induction motor is estimated to control a pulse width of the inverter by detecting the motor current without installing a speed sensor in the induction motor, there is provided a speed estimation period in which the exciting current is caused to vary at the time of activating the inverter in order to detect the torque current value. In the speed estimation period, a deviation between the detection value of the exciting current and the command value of the exciting current becomes large. Therefore, the connection failure detecting unit 6B does not determine the connection failure in an initial speed estimation period which is set in a predetermined period from the activation of the inverter. After the predetermined period from the activation of the inverter elapses, the connection failure detecting unit 6B performs the determination on the connection failure. In this way, it is possible to prevent an erroneous detection of the connection failure caused in the speed sensorless vector control by specifying an execution timing of determining the connection failure. The speed sensorless vector control and the function of determining the connection failure can be jointly used.

It has been known that a magnetic flux in the induction motor does not disappear right away but left even when the inverter is stopped. Further, a power-saving induction motor having low resistance is widely used in recent years, and thus it takes a long time for consuming the residual magnetic flux until the energy of the residual magnetic flux disappears. When the inverter is reactivated in a state where the residual magnetic flux is left, an excessive current may flow depending on an electromotive voltage generated by the residual magnetic flux and a phase of the voltage output from the inverter, and the inverter may be broken. Therefore, in this embodiment, demagnetization control is performed to discharge the exciting current before the inverter is stopped in order to rapidly remove the residual magnetic flux. Herein, a general railway vehicle repeats the operations such as stopping, power running, coasting, braking, and stopping, and the inverter is operated at the time of power running and braking. Therefore, the demagnetization control is performed at the time of coasting after power running and at the time of stopping after braking.

Since the exciting current is discharged in the period of the demagnetization control, the exciting current is temporarily increased, and a deviation with respect to the exciting current command value becomes large. Therefore, in a control period of the demagnetization control which is performed after a command to stop the inverter is input from the driving cab, the connection failure detecting unit 6B does not perform the determination on the connection failure. In this way, the erroneous detection of the connection failure caused by the demagnetization control can be prevented by specifying an execution timing of determining the connection failure, and the demagnetization control and the function of determining the connection failure can be jointly used.

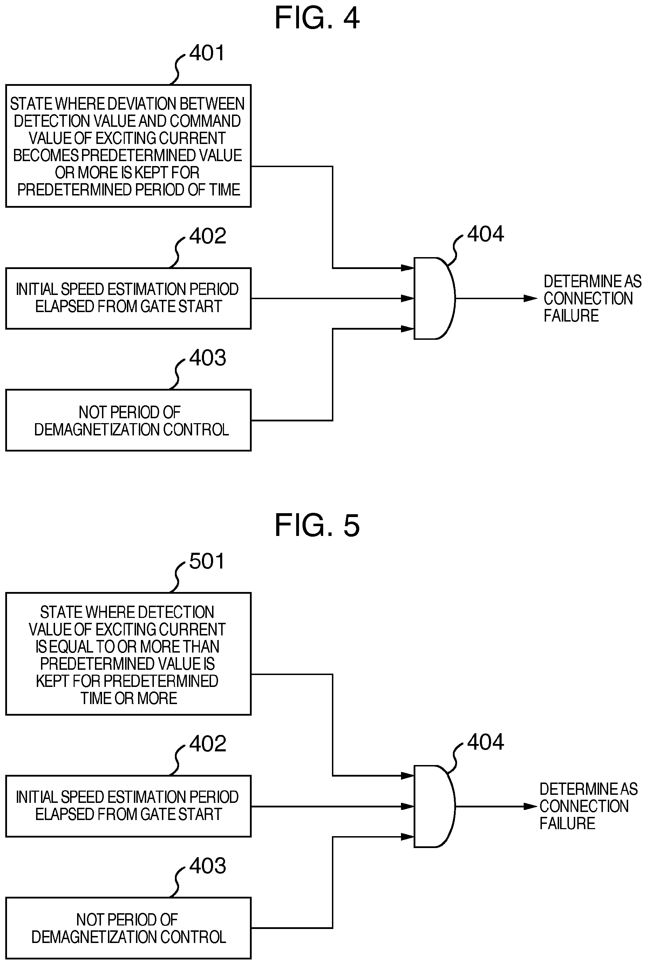

The description will be made using FIG. 4 about a determination condition which is used for detecting the connection failure by the connection failure detecting device 6. In Process 401, a deviation between an absolute value of the detection value of the exciting current and an absolute value of the command value of the exciting current is calculated, and it is determined whether a state where the deviation is equal to or more than a predetermined value is kept for a predetermined time or more. In a case where the state is kept for the predetermined time or more, a High signal is output to an AND circuit 404. In Process 402, it is determined whether the initial speed estimation period from a gate start to a predetermined time elapses. In a case where the initial speed estimation period elapses, the High signal is output to the AND circuit 404. In Process 403, it is determined whether it is in the period of the demagnetization control performed in a case where a command of coasting or stopping is input from the driving cab. In a case where it is not in the period of the demagnetization control, the High signal is output to the AND circuit 404. In a case where the High signal is input to each of Processes 401, 402, and 403, the AND circuit 404 determines that the connection failure occurs.

In the embodiment described above, the description has been made about an example in which the connection failure detecting device 6 determines the connection failure on the basis of a magnitude of the deviation between the absolute value of the detection current of the exciting current and the absolute value of the command value of the exciting current. However, in a case where the exciting current command value when the connection state to the induction motor is normal is controlled to be almost constant, the deviation between the detection value and the command value of the exciting current is not necessarily calculated. The connection failure can be determined on the basis of a magnitude of the detection value of the exciting current. The determination condition for detecting the connection failure of the connection failure detecting device 6 in the embodiment will be described using FIG. 5. In FIG. 5, only Process 501 is different from Process 401 of FIG. 4, and the other processes are the same. In Process 501, it is determined whether a state where the absolute value of the detection value of the exciting current is equal to or more than a predetermined value is kept for a predetermined time or more. In a case where the state is kept for the predetermined time or more, the High signal is output to the AND circuit 404. In a case where the High signal is input to each of Processes 501, 402, and 403, the AND circuit 404 determines that the connection failure occurs.

## Claims

1. A power conversion device that supplies AC power to a plurality of induction motors (8A, 8B, 8C, and 8D), comprising:
a current vector detecting unit (5) that generates a torque current detection value (Iqf) and an exciting current detection value (Idf) from a current detection value between the power conversion device and the plurality of induction motors (8A, 8B, 8C, and 8D);
a slip frequency calculating unit (3) that generates a slip frequency on the basis of a torque current command value (Iqp) and an exciting current command value (Idp);
a speed estimating unit (4) that generates an estimation speed of the induction motor on the basis of a deviation between the torque current detection value (Iqf) and the torque current command value (Iqp)
a connection failure detecting device (6) that detects a connection failure of the plurality of induction motors (8A, 8B, 8C, and 8D) on the basis of the exciting current detection value (Idf) ; and
a voltage vector calculation unit (1) that generates a voltage command value on the basis of the torque current command value (Iqp), the exciting current command value (Idp), and an inverter frequency generated on the basis of the slip frequency and the estimation speed such that the torque current detection value (Iqf) follows the torque current command value (Iqp).

2. The power conversion device according to claim 1,
wherein, in a case where a deviation between an absolute value of the exciting current detection value and an absolute value of the exciting current command value (Idp) is equal to or more than a predetermined value, the connection failure detecting device (6) detects the connection failure of the plurality of induction motors (8A, 8B, 8C, and 8D).

3. The power conversion device according to claim 1,
wherein, in a case where an absolute value of the exciting current detection value is equal to or more than a predetermined value, the connection failure detecting device (6) detects the connection failure of the plurality of induction motors (8A, 8B, 8C, and 8D).

4. The power conversion device according to claims 1 to 3,
wherein the connection failure detecting device (6) has a necessary condition for detecting the connection failure of the plurality of induction motors (8A, 8B, 8C, and 8D) when a predetermined period of time elapses after the power conversion device is activated, and
the exciting current is changed in the predetermined period of time to estimate an initial speed of the induction motor.

5. The power conversion device according to claims 1 to 4,
wherein the connection failure detecting device (6) has a necessary condition for detecting the connection failure of the plurality of induction motors (8A, 8B, 8C, and 8D) when a command to stop the power conversion device is not input from a driving cab, and
the exciting current is discharged after the command to stop the power conversion device is input from the driving cab to reduce a magnetic flux in the induction motor.

## Patentansprüche

1. Leistungswandlervorrichtung, die eine Vielzahl von Induktionsmotoren (8A, 8B, 8C und 8D) mit Wechselstromleistung versorgt und Folgendes umfasst:
eine Stromvektordetektionseinheit (5), die einen Drehmomentstromdetektionswert (Iqf) und einen Erregerstromdetektionswert (Idf) aus einem Stromdetektionswert zwischen der Leistungswandlervorrichtung und der Vielzahl von Induktionsmotoren (8A, 8B, 8C und 8D) erzeugt;
eine Schlupffrequenzberechnungseinheit (3), die eine Schlupffrequenz auf Grundlage eines Drehmomentsollwerts (Iqp) und eines Erregerstromsollwerts (Idp) erzeugt;
eine Geschwindigkeitsschätzungseinheit (4), die eine geschätzte Geschwindigkeit des Induktionsmotors auf Grundlage einer Abweichung zwischen dem Drehmomentstromdetektionswert (Iqf) und dem Drehmomentsollwert (Iqp) erzeugt;
eine Verbindungsunterbrechungsdetektionsvorrichtung (6), die eine Verbindungsunterbrechung der Vielzahl von Induktionsmotoren (8A, 8B, 8C und 8D) auf Grundlage des Erregerstromdetektionswerts (Idf) detektiert; und
eine Spannungsvektorberechnungseinheit (1), die einen Spannungssollwert auf Grundlage des Drehmomentsollwerts (Iqp), des Erregerstromsollwerts (Idp) und einer Wechselrichterfrequenz erzeugt, die auf Grundlage der Schlupffrequenz und der geschätzten Geschwindigkeit erzeugt wird, so dass der Drehmomentstromdetektionswert (Iqf) dem Drehmomentsollwert (Iqp) folgt.

2. Leistungswandlervorrichtung nach Anspruch 1,
wobei bei einer Abweichung zwischen einem Absolutwert des Erregerstromdetektionswerts und einem Absolutwert des Erregerstromsollwerts (Idp), die einem vorbestimmten Wert entspricht oder höher als dieser ist, die Verbindungsunterbrechungsdetektionsvorrichtung (6) eine Verbindungsunterbrechung der Vielzahl von Induktionsmotoren (8A, 8B, 8C und 8D) detektiert.

3. Leistungswandlervorrichtung nach Anspruch 1,
wobei, wenn ein Absolutwert des Erregerstromdetektionswerts einem vorbestimmten Wert gleich ist oder höher als dieser ist, die Verbindungsunterbrechungsdetektionsvorrichtung (6) eine Verbindungsunterbrechung der Vielzahl von Induktionsmotoren (8A, 8B, 8C und 8D) detektiert.

4. Leistungswandlervorrichtung nach einem der Ansprüche 1 bis 3,
wobei die Verbindungsunterbrechungsdetektionsvorrichtung (6) einen erforderlichen Zustand hat, um die Verbindungsunterbrechung der Vielzahl von Induktionsmotoren (8A, 8B, 8C und 8D) zu detektieren, wenn eine vorbestimmte Zeit vergeht, nachdem die Leistungswandlervorrichtung aktiviert wurde, und
der Erregerstrom in der vorbestimmten Zeit geändert wird, um eine Anfangsgeschwindigkeit des Induktionsmotors einzuschätzen.

5. Leistungswandlervorrichtung nach einem der Ansprüche 1 bis 4,
wobei die Verbindungsunterbrechungsdetektionsvorrichtung (6) einen erforderlichen Zustand hat, um die Verbindungsunterbrechung der Vielzahl von Induktionsmotoren (8A, 8B, 8C und 8D) zu detektieren, wenn ein Befehl zum Anhalten der Leistungswandlervorrichtung nicht von einem Führerstand eingegeben wird, und
der Erregerstrom nach Eingabe des Befehls zum Anhalten der Leistungswandlervorrichtung von dem Führerstand entladen wird, um einen Magnetfluss in dem Induktionsmotor zu reduzieren.

## Revendications

1. Dispositif de conversion de puissance qui fournit une puissance alternative à une pluralité de moteurs asynchrones (8A, 8B, 8C, et 8D), comprenant :
une unité de détection de vecteur de courant (5) qui génère une valeur de détection de courant de couple (Iqf) et une valeur de détection de courant d'excitation (Idf) à partir d'une valeur de détection de courant entre le dispositif de conversion de puissance et la pluralité de moteurs asynchrones (8A, 8B, 8C, et 8D) ;
une unité de calcul de fréquence de glissement (3) qui génère une fréquence de glissement sur la base d'une valeur de commande de courant de couple (Iqp) et d'une valeur de commande de courant d'excitation (Idp) ;
une unité d'estimation de vitesse (4) qui génère une vitesse d'estimation du moteur asynchrone sur la base d'un écart entre la valeur de détection de courant de couple (Iqf) et la valeur de commande de courant de couple (Iqp) ;
un dispositif de détection de défaillance de connexion (6) qui détecte une défaillance de connexion de la pluralité de moteurs asynchrones (8A, 8B, 8C, et 8D) sur la base de la valeur de détection de courant d'excitation (Idf) ; et
une unité de calcul de vecteur de tension (1) qui génère une valeur de commande de tension sur la base de la valeur de commande de courant de couple (Iqp), de la valeur de commande de courant d'excitation (Idp), et d'une fréquence d'onduleur générée sur la base de la fréquence de glissement et de la vitesse d'estimation de sorte que la valeur de détection de courant de couple (Iqf) suive la valeur de commande de courant de couple (Iqp).

2. Dispositif de conversion de puissance selon la revendication 1,
dans lequel, dans un cas dans lequel un écart entre une valeur absolue de la valeur de détection de courant d'excitation et une valeur absolue de la valeur de commande de courant d'excitation (Idp) est supérieur ou égal à une valeur prédéterminée, le dispositif de détection de défaillance de connexion (6) détecte la défaillance de connexion de la pluralité de moteurs asynchrones (8A, 8B, 8C, et 8D).

3. Dispositif de conversion de puissance selon la revendication 1,
dans lequel, dans un cas dans lequel une valeur absolue de la valeur de détection de courant d'excitation est supérieure ou égale à une valeur prédéterminée, le dispositif de détection de défaillance de connexion (6) détecte la défaillance de connexion de la pluralité de moteurs asynchrones (8A, 8B, 8C, et 8D).

4. Dispositif de conversion de puissance selon les revendications 1 à 3,
dans lequel le dispositif de détection de défaillance de connexion (6) a une condition nécessaire pour détecter la défaillance de connexion de la pluralité de moteurs asynchrones (8A, 8B, 8C, et 8D) lorsqu'une période de temps prédéterminée s'est écoulée après que le dispositif de conversion de puissance a été activé, et
le courant d'excitation est changé dans la période de temps prédéterminée pour estimer une vitesse initiale du moteur asynchrone.

5. Dispositif de conversion de puissance selon les revendications 1 à 4,
dans lequel le dispositif de détection de défaillance de connexion (6) a une condition nécessaire pour détecter la défaillance de connexion de la pluralité de moteurs asynchrones (8A, 8B, 8C, et 8D) lorsqu'une commande pour arrêter le dispositif de conversion de puissance n'est pas entrée à partir d'une cabine de commande, et
le courant d'excitation est déchargé après que la commande pour arrêter le dispositif de conversion de puissance a été entrée à partir de la cabine de commande pour réduire un flux magnétique dans le moteur asynchrone.
